# EUROPÄISCHE PATENTANMELDUNG

(11) **EP 2 166 367 A1**
(43) Veröffentlichungstag der Anmeldung: **24.03.2010**
(21) Anmeldenummer: 09170858.6
(22) Anmeldetag: 21.09.2009
(51) Int. Cl.: G01R 33/30

(54) **Vorrichtung und Verfahren zur Positionierung eines Kleintieres für eine MRI-Messung**

(30) Priorität: 23.09.2008 DE 102008048414
(71) Anmelder: Bruker BioSpin AG, 8117 Fällanden (CH)
(72) Erfinder: Wolke, Dietmar, 8050, Zürich (CH); Schmidig, Daniel, 8200, Schaffhausen (CH)
(74) Vertreter: Kohler Schmid Möbus

(57) **Zusammenfassung**

Eine Vorrichtung zur Durchführung von bildgebenden Magnetresonanzmessungen (=MRI) in einer interessierenden Region eines Kleintieres (3) mit einem MRI-Magnetsystem (7), mit einer Liege (5), auf der das Kleintier liegt, sowie mit einer Hochfrequenz (=HF)-Antenne (6), wobei die HF-Antenne und das Kleintier relativ zu einander positioniert werden können, ist **dadurch gekennzeichnet, dass** die Vorrichtung einen Schlitten (1) umfasst, auf dem die Liege zusammen mit dem darauf fixierbaren Kleintier sowohl außerhalb als auch innerhalb des MRI-Magnetsystems verschoben werden kann, und dass die HF-Antenne starr am Schlitten befestigt ist. Damit steht eine - gegebenenfalls bei einer bereits vorhandenen Tomographieapparatur leicht nachrüstbare - Vorrichtung zur relativen Positionierung des Kleintiers und der HF-Antenne für eine MRI-Messung zur Verfügung, mit welcher - bei einfacher Handhabung und ohne großen technischen Zusatzaufwand - diese Positionierung sowohl innerhalb als auch außerhalb des MRI-Magneten zu bewerkstelligen ist.

## Beschreibung

### Bereich der Erfindung

Die vorliegende Erfindung bezieht sich auf eine Vorrichtung, welche im Zusammenhang mit der Durchführung von MRS- (Magnetic resonance spectroscopy) und MRI- (magnetic resonance imaging) Experimenten an Kleintieren steht. Insbesondere bezieht sich die Erfindung auf eine Vorrichtung und ein Verfahren mit dem Ziel, eine einfache und exakte Positionierung des Kleintiers gegenüber der Hochfrequenz (HF)-Antenne zu erreichen, wobei unter ,Antenne' eine Vorrichtung zum Senden und Empfangen elektromagnetischer Wellen verstanden wird.

### Hintergrund der Erfindung

### Der Prozess der Bilderzeugung

Wenn ein Patient oder ein Tier, im Folgenden immer als das "Messobjekt" bezeichnet, in ein starkes Magnetfeld gelegt wird, wird sein Gewebe aufgrund des Verhaltens bestimmter Atomkerne magnetisiert. Dieses Kernmagnetfeld hat einen Bestandteil, der bei einer spezifischen Frequenz rotiert. Das Phänomen ist bekannt als Kernspinresonanz (NMR). Die Resonanzfrequenz ist proportional zur Stärke des starken Magnetfelds, und wird als Larmor-Frequenz bezeichnet. Praktisch alle klinischen Anwendungen der Magnetresonanz (MR) bauen auf der Manipulierung des Kernmagnetfelds des Wasserstoffs auf, der bei einer Feldstärke von 1,5 Tesla eine Larmor-Frequenz von 63,87 MHZ hat. Das MR-Bild ist eine Darstellung der NMR Signalintensität. Um zu einem nützlichen Bild zu kommen, müssen verschiedene Gewebearten unterschiedliche Signalintensitäten (Kontrast) ergeben. Dazu muss der MRI Scanner erstens nachweisbare NMR Signale in den Geweben verursachen und zweitens diese räumlich auflösen können.

### Übersicht über das MRI System

MRI-Systeme sind weit verbreitete medizinische und diagnostische Geräte. Die primären Komponenten eines MRI-Systems sind der Magnet, welcher ein stabiles und sehr starkes Magnetfeld (B0) erzeugt, die Gradientenspulen, welche ein zusätzliches variables Magnetfeld erzeugen und die HF-Sende-Antenne, welche benutzt wird um Energie ins Messobjekt zu senden und die räumliche Position zu kodieren. HF-Empfangs-Antennen werden verwendet um das NMR-Signal aus dem Messobjekt zu empfangen. Es ist möglich eine HF-Antenne sowohl als Empfangs- als auch als Sende-Antenne zu verwenden. Ein Computer kontrolliert den gesamten Vorgang und wird benötigt um die empfangene Information zu verarbeiten.

### Definition: "Region of interest"

Als Region of Interest (ROI) wird im Folgenden ein Bereich des Messobjektes bezeichnet, der von besonderer Bedeutung ist. Dies kann z.B. ein Organ oder ein Körperteil eines zu untersuchenden Kleintieres sein.

### Definition "Field of View"

Das Field of View (FOV) sei definiert als die Größe des Gebietes in welchem von der HF-Antenne ein ausreichend starkes Magnetfeld erzeugt wird. Alles was außerhalb des FOV einer HF-Antenne liegt kann im MR-Bild nicht dargestellt werden.

### Definition "Signal zu Rausch Verhältnis"

Das Signal zu Rausch Verhältnis (SNR) ist in der Magnetresonanztomografie ein Kriterium für die Bildqualität. Das SNR ist das Verhältnis zwischen dem effektiven, vom MRI-System aufgenommenem NMR-Signal und zufälligen vom MRI-System aufgenommenem Rauschsignalen.

### Stand der Technik

HF-Antennensysteme von MRI-Geräten können in zwei Kategorien eingeteilt werden. In der einen Kategorie befinden sich Antennensysteme, bei welchen mit derselben HF-Antenne sowohl gesendet als auch empfangen wird, so genannte Sende-Empfangs-Antennen.

In der zweiten Kategorie befinden sich Antennensysteme, bei welchen zum Senden und zum Empfangen der HF-Signale jeweils eine separate HF-Antenne verwendet wird, eine HF-Antenne zum Senden der HF-Signale, die so genannte Sende-Antenne und eine HF-Antenne zum Empfangen der NMR-Signale, die so genannte Empfangs-Antenne.

Bei MR-Untersuchungen von Organen oder Körperteilen von Kleintieren werden zum Empfang der Kernspinresonanzsignale (MR-Signale) zunehmend der Geometrie der ROI angepasste HF-Antennen eingesetzt. Diese HF-Antennen werden bei der Untersuchung möglichst nah an der Körperoberfläche direkt am zu untersuchenden Organ bzw. Körperteil des Kleintieres angeordnet. Im Gegensatz zu weiter entfernt vom Kleintier angeordneten HF-Antennen, die in der Regel zur Erzeugung eines Schnittbildes durch das gesamte Kleintier genutzt werden, sind HF-Antennen dieser Art wesentlich kleiner in den geometrischen Abmaßen. Dadurch wird der durch dielektrische Verluste innerhalb des Körpers des Kleintieres verursachte Rauschanteil reduziert, was dazu führt, dass das SNR einer der Geometrie der ROI angepassten HF-Antenne prinzipiell besser ist, als das einer weiter entfernten Antenne. Nachteilig ist jedoch, dass eine kleinere HF-Antenne nur in der Lage ist, ein Bild innerhalb einer begrenzen räumlichen Ausdehnung zu erzeugen, welche in der Größenordnung der typischen Dimensionen der HF-Antenne liegt.

Bei den oben beschriebenen HF-Antennen, welche der Geometrie der ROI angepasst sind, handelt es sich häufig um Oberflächenspulen bzw. so genannte Phased-Array-Spulen. Der oben beschriebene Sachverhalt trifft jedoch unverändert auch auf Spulentypen wie Birdcage-, Solenoid-, Helmholtzspulen und StripLine-Antennen zu.

Unter Oberflächenspule wird eine Schleife von leitendem Material verstanden, welche als HF-Antenne fungiert und sich in direktem Kontakt mit dem Messobjekt befindet.

Eine Phased-Array-Spule ist eine Anordnung aus mehreren HF-Antennen, welche parallel betrieben werden.

Birdcage Spulen sind z.B. aus US-A 4,680,548 bekannt. Ihre beiden Leiterschleifen haben in der Regel die Form zweier gleich großer koaxialer Kreise, die durch die Leiter miteinander verbunden sind. Dieser Aufbau verleiht der MR-Spulenanordnung das Aussehen eines Vogelkäfigs (engl.: birdcage), weshalb die Spulenanordnung in der Fachwelt oft auch als "Birdcage-Spule" bezeichnet wird.

### Das Verkleinern der HF-Antenne bringt nun ein wesentliches Problem mit sich:

Da das FOV einer verkleinerten HF-Antenne entsprechend der Dimensionen der HF-Antenne kleiner ist, wird es dementsprechend schwieriger, das Kleintier gegenüber der HF-Antenne so zu positionieren, dass das zu untersuchende Organ oder Körperteil (allgemeiner: die ROI) innerhalb des FOV der HF-Antenne zu liegen kommt. Insbesondere wird es häufig nötig, die HF-Antenne möglichst nahe am Kleintier zu positionieren, da die Intensität des HF-Feldes bei kleineren HF-Antennen wesentlich schneller abfällt. So besagt eine Faustregel, dass für eine Oberflächenspule das FOV um einen halben Spulendurchmesser ins Messobjekt hinein reicht.

Als Folge davon muss der Positionierung des Kleintieres gegenüber der HF-Antenne immer größere Beachtung geschenkt werden.

Häufig ist eine exakte Positionierung der ROI gegenüber der HF-Antenne außerhalb des Magneten nicht möglich, weil die Position der ROI ohne MR-Bildgebung nicht exakt genug festgestellt werden kann. Z.B. wird für MR-Bildgebung der Herzregion von Kleintieren die Position des Herzens durch Ertasten festgestellt, was Fehler in der Positionierung von ca. ±5mm zur Folge hat.

Im aktuellen Stand der Technik wird dieses Problem der Positionierung des Kleintiers gegenüber der HF-Antenne im Wesentlichen auf zwei verschiedene Arten gelöst:

### Typ A:

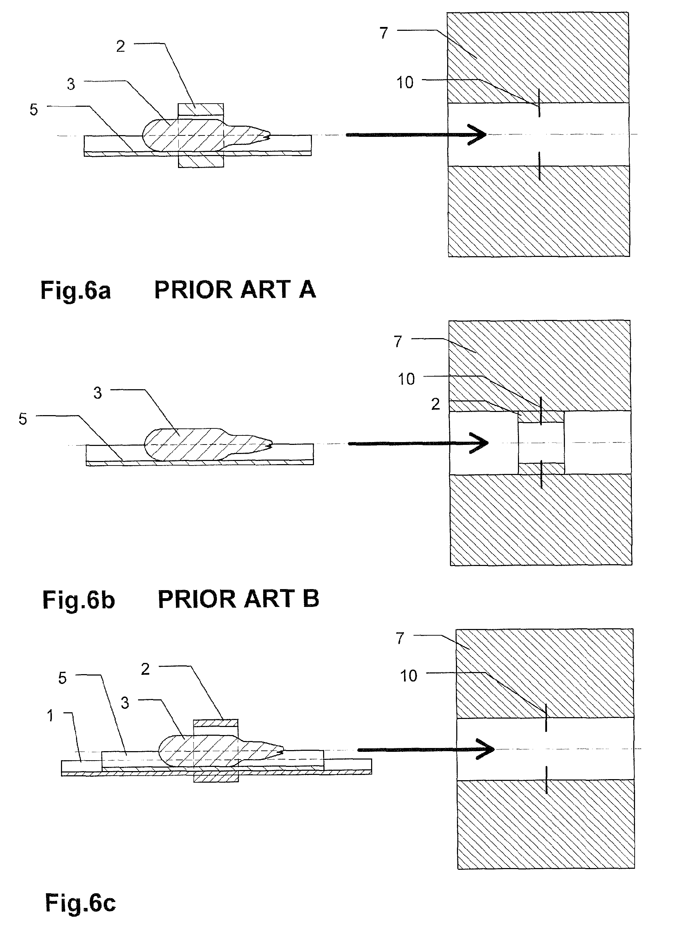

Fig.6a stellt eine typische Vorrichtung dar, wie sie Stand der Technik zur Positionierung eines Kleintiers 3 gegenüber einer HF-Antenne ist. Dabei befindet sich das Kleintier 3 auf einer Liege 5. Das Kleintier 3 ist auf dieser Liege 5 nun entweder mit einer stereotaktischen Fixierung oder mit anderen Hilfsmitteln befestigt, oder es befindet sich unfixiert auf der Liege 5. Im Wesentlichen wird das Kleintier 3 jedoch zusammen mit der Liege 5 bewegt. Zur Positionierung der HF-Antenne gegenüber dem Kleintier 3 wird diese nun in irgendeiner Art an der Liege 5 angebracht. Kleintier 3 mit Liege 5 und dazu positionierte HF-Antenne werden nun als Einheit in den MRI-Magneten 7 geschoben. Bezeichnend für diesen Typ von Vorrichtung ist die Tatsache, dass die relative Position von Kleintier 3 und HF-Antenne nicht mehr verändert werden kann, sobald sich die Vorrichtung erst einmal im Magneten befindet.

US6275723B1 beschreibt eine Vorrichtung zur stereotaktischen Fixierung eines Kleintieres für MRI. Es wird beschrieben, wie diese Vorrichtung im Magneten positioniert werden kann und wie auf der Vorrichtung zusätzlich eine HF-Antenne fixiert werden kann.

US2001053878A1 beschreibt eine Befestigungsvorrichtung für Neuroimaging von Tieren in MRI-Systemen. Dabei wird das Tier auf einer Liege zusammen mit einer Halterung für den Kopf des Tieres befestigt. Es wird beschrieben, wie die Halterung für den Kopf des Tieres eine HF-Antenne enthalten kann.

Konventionelle Vorrichtungen des Typs A haben das Problem, dass die relative Position von Kleintier und HF-Antenne nicht mehr verändert werden kann, sobald sich die Vorrichtung erst einmal im Magneten befindet. Stellt sich im MR-Bild heraus, dass die HF-Antenne relativ zum Tier nicht richtig positioniert ist, weil z.B. die Position des Herzens nicht korrekt ertastet wurde, muss die Vorrichtung aus dem Magneten entfernt werden, und das Tier muss außerhalb des Magneten gegenüber der HF-Antenne wieder neu positioniert werden.

### Typ: B

Fig.6b stellt eine zweite typische Vorrichtung, wie sie Stand der Technik zur Positionierung eines Kleintiers 3 gegenüber einer HF-Antenne ist, dar. Dabei befindet sich das Kleintier 3 auf einer Liege 5. Das Kleintier 3 ist auf dieser Liege 5 nun entweder mit einer stereotaktischen Fixierung oder mit anderen Hilfsmitteln befestigt, oder es befindet sich unfixiert auf der Liege 5. Im Wesentlichen wird das Kleintier 3 jedoch zusammen mit der Liege 5 bewegt. Die HF-Antenne ist hierbei nicht fest mit der Liege 5 verbunden, sondern befindet sich im MRI-Magneten. Zur Positionierung der HF-Antenne gegenüber dem Kleintier 3 wird die Liege 5 zusammen mit dem Kleintier 3 in den MRI-Magneten 7 und die HF-Antenne eingeführt. Die relative Position vom Kleintier 3 gegenüber der HF-Antenne kann innerhalb des Magneten, durch Bewegen der Liege 5 verändert werden. Bezeichnend für diesen Typ von Vorrichtung ist die Tatsache, dass eine relative Positionierung von Kleintier 3 und HF-Antenne außerhalb des Magneten nicht möglich ist.

US2005027190A1 beschreibt ein System, welches das Abbilden eines Messobjektes in einem MRI-System erleichtert. Das System besteht unter anderem aus Stützen, welche die Montage der HF-Antenne im Magneten erleichtern. Die Druckschrift beschreibt auch eine Vorrichtung zur radialen und axialen Positionierung einer Kleintierhalterung gegenüber der HF-Antenne. Die Möglichkeit, das Tier zusammen mit der HF-Antenne außerhalb des Magneten zu präparieren, ist damit jedoch nicht gegeben.

WO9428431A1 beschreibt eine Vorrichtung zur radialen und axialen Positionierung einer Kleintierhalterung sowie einer HF-Antenne zum Magnetsystem ohne die Möglichkeit, das Tier zusammen mit der HF-Antenne in den Magneten zu befördern.

Konventionelle Vorrichtungen des Typs B haben das Problem, dass die relative Positionierung des Messobjekts gegenüber der HF-Antenne außerhalb des Magneten nicht kontrolliert werden kann. Insbesondere bei der Arbeit mit lebenden Tieren und wenn das Kleintier möglichst nahe an der HF-Antenne positioniert werden soll, ist die Möglichkeit diese Positionierung außerhalb des Magneten überprüfen zu können aber von großer Bedeutung. Findet die Positionierung erst innerhalb des Magneten statt und kann nicht visuell kontrolliert werden, besteht die Gefahr, das Kleintier dabei zu verletzen.

### Die erfindungsgemäße Vorrichtung

Aufgabe der vorliegenden Erfindung ist es, eine - gegebenenfalls bei einer bereits vorhandenen Tomographieapparatur leicht nachrüstbare - Vorrichtung zur relativen Positionierung eines Kleintiers und einer HF-Antenne für eine MRI-Messung vorzustellen, mit welcher - bei einfacher Handhabung und ohne großen technischen Zusatzaufwand - diese Positionierung sowohl innerhalb als auch außerhalb des MRI-Magneten zu bewerkstelligen ist.

Dieses Ziel wird erfindungsgemäß dadurch erreicht, dass zusätzlich zur Liege, auf oder in der sich das Kleintier befindet, ein Schlitten vorgesehen ist, auf dem die Liege sowohl innerhalb als auch außerhalb des MRI-Magneten verschoben werden kann, wobei die HF-Antenne fest mit dem Schlitten verbunden ist.

### Vorteile

Fig.6c stellt eine erfindungsgemäße Vorrichtung zur Positionierung eines Kleintiers 3 gegenüber einer an einem Antennenhalter 2 angebrachten HF-Antenne 6 dar. Dabei befindet sich das Kleintier 3 auf einer Liege 5. Das Kleintier 3 ist auf dieser Liege 5 nun entweder mit einer stereotaktischen Fixierung oder mit anderen Hilfsmitteln befestigt, oder es befindet sich unfixiert auf der Liege 5. Das Kleintier 3 kann zusammen mit der Liege 5 bewegt werden. Ein wesentlicher Bestandteil der Erfindung ist ein zusätzliches Trägerelement, der so genannte Schlitten 1, in welchem sich die Liege 5 befindet und worin die Liege 5 bewegt werden kann. Das Kleintier 3 ist nicht mit dem Schlitten 1 verbunden. Die HF-Antenne 6 ist über den Antennenhalter 2 am Schlitten 1 befestigt und nicht mit der Liege 5 und dem Kleintier 3 verbunden. Zur Positionierung der HF-Antenne gegenüber dem Kleintier 3 wird die Liege 5 im Schlitten 1 bewegt. Kleintier 3 mit Liege 5 und Schlitten 1 sowie mit daran befestigter HF-Antenne 6 werden als Einheit in den MRI-Magneten 7 geschoben. Durch Bewegen der Liege 5 im Schlitten 1 kann die relative Position von Kleintier 3 und HF-Antenne auch im MRI-Magneten 7 noch verändert werden.

Der wesentliche Vorteil einer Positionierung des Kleintieres gegenüber der HF-Antenne außerhalb des Magneten besteht darin, dass die korrekte Lage des Tieres einfach visuell überprüft werden kann. Insbesondere kann kontrolliert werden, ob dem Kleintier bei knapper Positionierung gegenüber der HF-Antenne kein Schaden zugefügt wird. Befände sich die HF-Antenne bereits im Magneten und das Kleintier würde dort gegenüber der HF-Antenne positioniert, wäre eine visuelle Kontrolle nicht möglich.

Der wesentliche Vorteil einer Positionierung innerhalb des Magneten besteht darin, dass die Position der ROI mit einem MR-Bild verifiziert und gegebenenfalls korrigiert werden kann ohne das Kleintier aus dem Magneten zu entfernen.

Mit Hilfe der vorliegenden Erfindung können sowohl die Vorteile einer Positionierung außerhalb als auch die Vorteile einer Positionierung innerhalb des Magneten jeweils vollständig genutzt werden.

In einer vorteilhaften Ausgestaltung der Erfindung lässt sich außerhalb des Magneten eine Grobpositionierung des Kleintieres gegenüber der HF-Antenne erreichen, indem das Kleintier dementsprechend auf der Liege fixiert wird.

Innerhalb des Magneten erreicht man eine Feinpositionierung durch Verschieben der Liege im Schlitten.

Unter ,Grobpositionierung' versteht man dabei eine Positioniergenauigkeit von ±1cm, unter ,Feinpositionierung' eine Positioniergenauigkeit von ±0.5mm.

### Detaillierte Beschreibung der Erfindung

Nachstehend wird die Art und Weise der Verwirklichung der vorliegenden Erfindung im Einzelnen erläutert. In diesem Zusammenhang ist es nicht beabsichtigt, die vorliegende Erfindung auf genau diese Art und Weise der Verwirklichung zu beschränken.

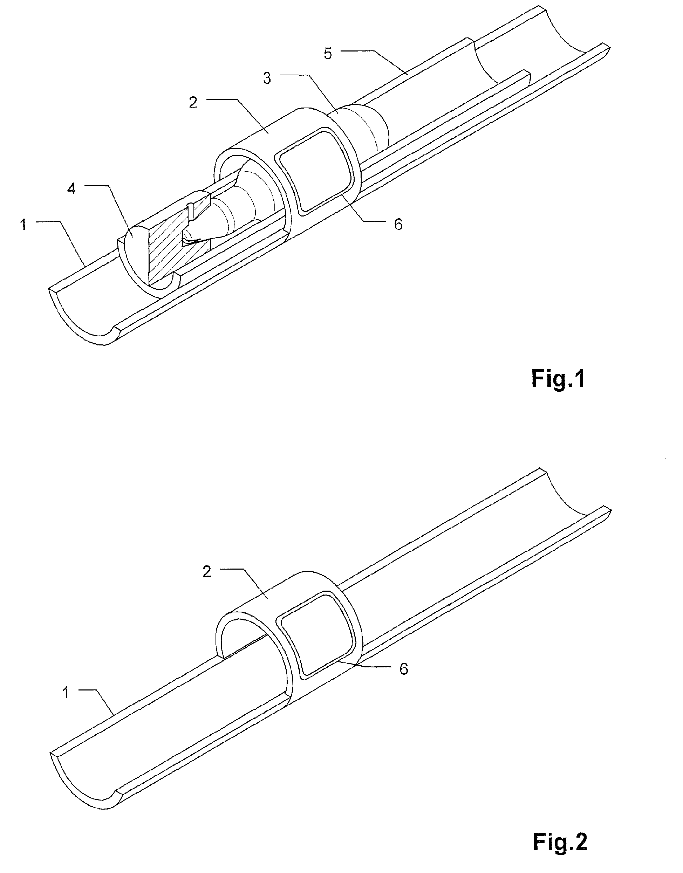

Die grundlegende Konstruktion einer erfindungsgemäßen Vorrichtung zur relativen Positionierung eines Kleintiers 3 gegenüber einer HF-Antenne 6 ist in Fig.1 dargestellt. Wie in Fig.1 gezeigt, umfasst die erfindungsgemäße Vorrichtung drei Hauptkomponenten, nämlich die Liege 5, den Schlitten 1 und die an einem Antennenhalter 2 angebrachte HF-Antenne 6.

Die Liege 5 dient dabei als Aufnahme für das Kleintier 3, d.h. das Kleintier 3 wird auf der Liege 5 grob positioniert und gegebenenfalls fixiert. Zur groben Positionierung des Kleintiers 3 auf der Liege 5 kann diese mit einer Markierung des magnetischen Zentrums versehen sein. Diese Markierung bezieht sich auf die Nullposition der Liege 5 gegenüber dem Schlitten 1.

Der Schlitten 1 dient als Aufnahme für die Liege 5, d.h. die Liege 5 befindet sich im Schlitten 1 und kann relativ zu diesem bewegt werden. Eine Skala, die auf dem Schlitten 1 vorgesehen werden kann, erlaubt es, die relative Position der Liege 5 zum Schlitten 1 abzulesen.

### HF-Antenne

Fig.2 zeigt die HF-Antenne 6 im Schlitten 1. Die HF-Antenne 6 ist über den Antennenhalter 2 fest im Schlitten 1 integriert oder in anderer Art und Weise starr am Schlitten 1 befestigt. Als HF-Antenne kann eine Oberflächenspule, eine StripLine-Antenne oder eine Phased-Array-Antenne eingesetzt werden. Die HF-Antenne 6 kann entweder ausschließlich als Empfangs-Antenne verwendet werden, wobei dann eine zweite Antenne zur Erzeugung eines HF-Sendesignals vorgesehen ist. Letztere kann sowohl fest im MRI-Magneten 7 montiert sein, als auch zusammen mit der Empfangs-Antenne fix auf dem Schlitten 1 befestigt sein. Alternativ kann die HF-Antenne 6 aber auch so gestaltet sein, dass mit ihr sowohl gesendet als auch empfangen werden kann.

Als Volumenspulen bezeichnet man HF-Antennen, welche einen größeren Bereich mit einem weitgehend homogenen B1-Feld ausleuchten. Es sind dies unter anderem so genannte Birdcage-Resonatoren, Helmoltz-Spulen und Solenoid-Spulen. In speziellen Fällen kann der Einsatz der erfindungsgemäßen Vorrichtung auch mit so genannten Volumenspulen sinnvoll sein.

### Abstimmnetzwerk, HF-Leitungen

Elektronische Komponenten, welche der Impedanzanpassung der Spule dienen, das so genannte Abstimmnetzwerk der HF-Antenne 6 und die dazugehörigen HF-Leitungen sind direkt im Schlitten 1 untergebracht.

### Vorverstärker

Bevor das von der HF-Antenne 6 empfangene NMR-Signal weiterverarbeitet wird, muss dieses Signal verstärkt werden. Dies geschieht durch eine oder mehrere Stufen von Vorverstärkern, die direkt im Schlitten 1 untergebracht sind.

### Fixierung (verschiebbar in der Liege):

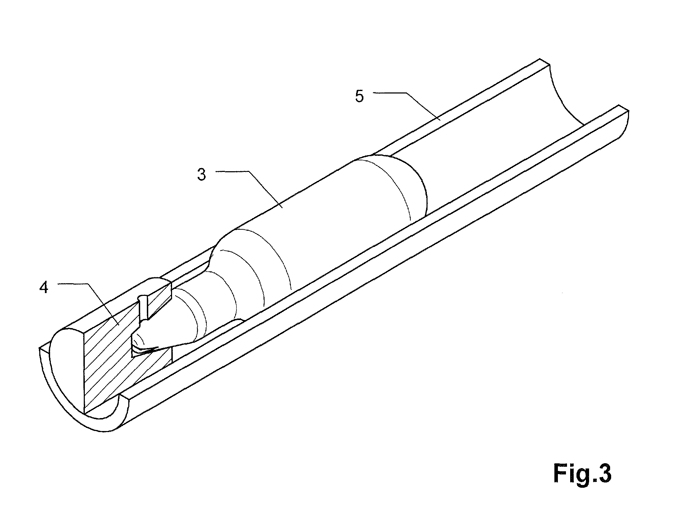

Fig.3 zeigt, wie das Kleintier 3 mit einer Fixierung auf der Liege 5 befestigt wird. Die Fixierung kann eine stereotaktische Fixierung oder eine einfache Zahnstange umfassen, mit welcher das Kleintier 3 in Position gehalten wird.

Durch Verschieben der Fixierung auf der Liege 5 kann die relative Position von Kleintier 3 und Liege 5 eingestellt werden. In der endgültigen Position kann die Fixierung an der Liege 5 befestigt werden, um eine ungewollte Verschiebung der Fixierung gegenüber der Liege 5 zu verhindern und das Kleintier 3 fest mit der Liege 5 zu verbinden.

### Temperierung

Die erfindungsgemäße Vorrichtung kann eine Temperiervorrichtung für das Kleintier 3 aufweisen. Bei vorteilhaften Weiterbildungen umfasst die Temperiervorrichtung einen Kanal, der in mäanderförmiger Weise die Liege 5 durchzieht. Durch den Kanal fließt ein temperaturgeregeltes Temperiermedium, welches die Liege 5 im Bereich des Kleintieres 3 auf eine gewünschte Temperatur bringt.

### Narkosegas

Ausführungsformen der erfindungsgemäßen Vorrichtung können eine, vorzugsweise integrierte, Narkosegasleitung aufweisen. Das Narkosegas fließt dabei durch einen in der Liege 5 ausgebildeten Kanal bis zur Fixierung des Kleintieres 3. Das Narkosegas wird dem Kleintier 3 über eine Narkosemaske 4 zugeführt, die gleichzeitig zur Fixierung des Kleintieres 3 dient.

### Thermofühler

Die erfindungsgemäße Vorrichtung kann eine integrierte Signalleitung für einen Thermofühler umfassen. Das Kabel des Thermofühlers ist dann vorteilhafter Weise direkt in der Liege 5 integriert.

### Form und Größe der HF-Antenne

Die HF-Antenne 6, welche zur erfindungsgemäßen Vorrichtung gehört, sollte in Größe und Form der ROI 9 angepasst sein.

### Radiale und axiale Bewegung und Verdrehsicherung

In der erfindungsgemäßen Vorrichtung kann die Liege 5 im Schlitten 1 axial und/oder radial bewegt werden. Bei einem axial beweglichen Schlitten 1 kann zusätzlich eine Sicherung gegen Verdrehung implementiert sein.

### Unmagnetisch

Die Bestandteile der erfindungsgemäßen Vorrichtung sollten aus unmagnetischen Materialien bestehen, um die Homogenität des B0 zu gewährleisten. Eine Suszeptibilität zwischen -15ppm und +15ppm wird in diesem Fall als unmagnetisch bezeichnet.

### Automatisiertes Verschieben der Liege im Schlitten

Bei bevorzugten Ausführungsformen kann die Liege 5 im Schlitten 1 automatisch bewegt werden.

### Ferngesteuertes automatisiertes Verschieben der Liege im Schlitten

Vorteilhaft sind auch Weiterbildungen, bei denen die Liege 5 im Schlitten 1 ferngesteuert, automatisch bewegt wird. Dies hat den Vorteil, dass der Bediener des MRI-Systems die relative Position von Kleintier 3 und HF-Antenne 6 direkt vom Platz aus, wo die MR-Bilddaten dargestellt werden, korrigieren kann.

### Verfahren

Nachstehend wird die Art und Weise der Durchführung eines Verfahrens zur relativen Positionierung von Kleintier 3 und HF-Antenne 6 erläutert, wobei das beschriebene Verfahren die Verwendung erfindungsgemäßen Vorrichtung voraussetzt. In diesem Zusammenhang ist nicht beabsichtigt, das vorliegende Verfahren oder die vorliegende Erfindung auf genau diese Art und Weise der Verwirklichung zu beschränken.

In der Regel ist ein zu untersuchendes Organ oder Körperteil des Kleintieres 3 die ROI und wird zunächst visuell oder durch Ertasten lokalisiert. Nachdem die ROI lokalisiert ist, kann der Bediener anhand von Markierungen auf der Liege 5 das Kleintier 3 so auf der Liege 5 positionieren, dass sich die ROI 9 bei einer Markierung des magnetischen Zentrums 10 des MRI-Magnetsystems 7 auf der Liege 5 befindet. In dieser Position wird das Kleintier 3 mit der Fixiereinrichtung auf der Liege 5 befestigt. Anschließend wird die Liege 5 in den Schlitten 1 gelegt und gegenüber der HF-Antenne 6 grob positioniert.

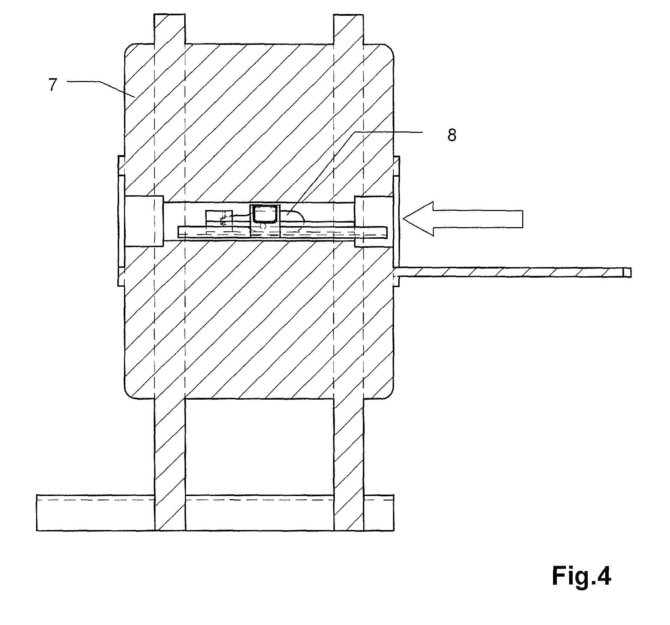

Kleintier 3 mit Liege 5 und Schlitten 1 werden - wie in Fig. 4 gezeigt - als Einheit 8 in den MRI-Magneten 7 eingeführt, wobei der Schlitten 1 mit der HF-Antenne 6 gegenüber dem magnetischen Zentrum 10 des MRI-Magneten 7 positioniert wird.

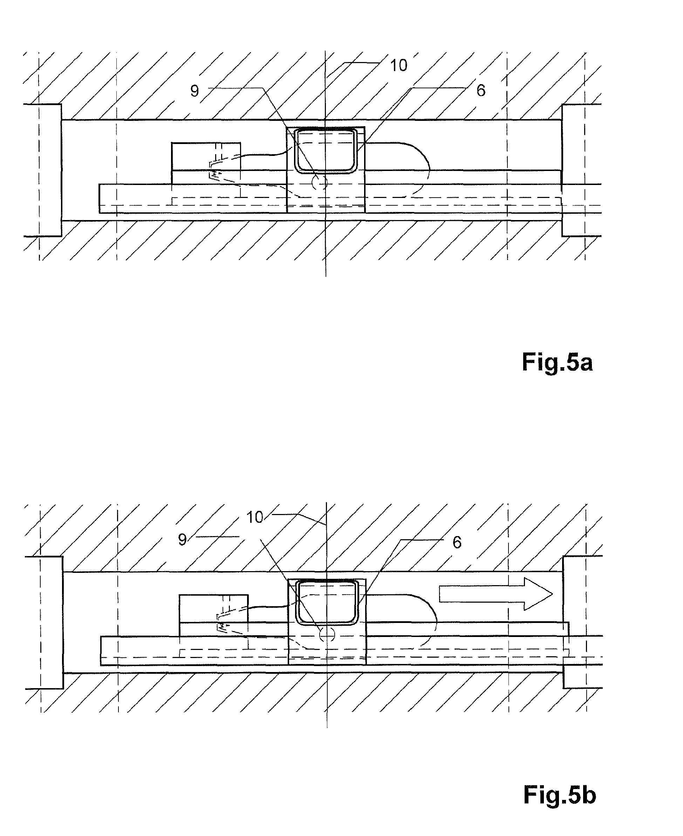

In diesem Zustand wird ein MRI-Experiment durchgeführt. Im MR-Bild kann nun die Verschiebung der ROI 9 gegenüber dem mit dem magnetischen Zentrum 10 des MRI-Magneten 7 in Messposition zusammen fallenden Zentrum der HF-Antenne 6 festgestellt werden. In Fig.5a ist der Fall dargestellt, dass die ROI 9 gegenüber dem magnetischen Zentrum 10 verschoben ist. Ohne den Schlitten 1 aus dem MRI-Magneten 7 zu entfernen, kann nun die relative Position der ROI 9 zur HF-Antenne 6 um denjenigen Wert verändert werden, welcher als Verschiebung aus dem MR-Bild abgelesen wurde. Dazu wird, wie in Fig.5b dargestellt, die Liege 5 im Schlitten 1 um ebendiesen Wert verschoben. Dadurch wird eine Positionierung der ROI 9 im Zentrum der HF-Antenne 6 erreicht.

Der Vorgang der Durchführung eines MRI-Experimentes und der Positionskorrektur im Magneten erfolgt iterativ.

Nachdem die relative Position von ROI 9 und HF-Antenne 6 einmal stimmt, können die endgültigen MR-Experimente durchgeführt werden.

### Liste der Figuren

| | |
|---|---|
| **Fig.1** | Erfindungsgemäße Vorrichtung mit Schnitt durch die Narkosemaske |
| **Fig.2** | Schlitten mit HF-Antennenhalter und HF-Antenne |
| **Fig.3** | Liege mit Schnitt durch die Narkosemaske und Kleintier |
| **Fig.4** | Schnittansicht durch einen MRI-Magneten mit eingebrachter Vorrichtung |
| **Fig.5a** | Schnittansicht durch den Magneten. Die Position des Herzens des Tieres wurde festgestellt. Es liegt außerhalb des magnetischen Zentrums. |
| **Fig.5b** | Schnittansicht durch den Magneten. Die Position des Herzens des Tieres wurde korrigiert. |
| **Fig.6a** | Darstellung des Standes der Technik, Variante A |
| **Fig.6b** | Darstellung des Standes der Technik, Variante B |
| **Fig.6c** | Darstellung der Neuerung in der vorliegenden Erfindung |

### Bezugszeichenliste

| | |
|---|---|
| **1** | Schlitten |
| **2** | HF-Antennenhalter |
| **3** | Kleintier |
| **4** | Narkosemaske |
| **5** | Liege |
| **6** | HF-Antenne |
| **7** | MRI-Magnetsystem |
| **8** | Gesamtes Messsystem |
| **9** | ROI |
| **10** | magnetisches Zentrum |

## Patentansprüche

1. Vorrichtung zur Durchführung von bildgebenden Magnetresonanzmessungen (=MRI) in einer interessierenden Region (=ROI) (9) eines Kleintieres (3) mit einem MRI-Magnetsystem (7), mit einer Liege (5), auf der das Kleintier (3) liegt, sowie mit einer Hochfrequenz (=HF)-Antenne (6), wobei die HF-Antenne (6) und das Kleintier (3) relativ zu einander positioniert werden können,
**dadurch gekennzeichnet,**
**dass** die Vorrichtung einen Schlitten (1) umfasst, auf dem die Liege (5) zusammen mit dem darauf fixierbaren Kleintier (3) sowohl außerhalb als auch innerhalb des MRI-Magnetsystems (7) verschoben werden kann, und dass die HF-Antenne (6) starr am Schlitten (1) befestigt ist.

2. Vorrichtung nach Anspruch 1, **dadurch gekennzeichnet, dass** die HF-Antenne (6) eine Empfangs-Antenne ist, und dass eine zweite HF-Antenne zur Erzeugung eines HF-Sendesignals vorgesehen ist.

3. Vorrichtung nach Anspruch 1, **dadurch gekennzeichnet, dass** mit der fest mit dem Schlitten (1) verbundenen HF-Antenne (6) sowohl gesendet als auch empfangen werden kann.

4. Vorrichtung nach einem der vorgehenden Ansprüche, **dadurch gekennzeichnet, dass** Signalleitungen, welche die HF-Antenne (6) mit einem oder mehreren Vorverstärkern verbinden, und/oder der/die Vorverstärker und/oder ein Abstimmnetzwerk im Schlitten (1) integriert sind.

5. Vorrichtung nach einem der Ansprüche 1 bis 5, **dadurch gekennzeichnet, dass** die Liege (5) im Schlitten (1) axial verschiebbar ist.

6. Vorrichtung nach einem der Ansprüche 1 bis 5, **dadurch gekennzeichnet, dass** die Liege (5) im Schlitten (1) radial verstellbar ist.

7. Vorrichtung nach einem der vorgehenden Ansprüche, **dadurch gekennzeichnet, dass** die Bestandteile der Vorrichtung eine maximale magnetische Suszeptibilität zwischen -15 und +15ppm aufweisen.

8. Vorrichtung nach einem der vorgehenden Ansprüche, **dadurch gekennzeichnet, dass** Versorgungsschläuche, insbesondere eine Narkosegasleitung, vorgesehen, vorzugsweise fix im Schlitten (1) integriert sind.

9. Vorrichtung nach einem der vorgehenden Ansprüche, **dadurch gekennzeichnet, dass** eine Narkosemaske (4) vorgesehen ist, über die dem Kleintier (3) Narkosegas zugeführt werden kann, und dass die Narkosemaske (4) gleichzeitig zur Fixierung des Kleintieres (3) ausgebildet ist.

10. Vorrichtung nach einem der vorgehenden Ansprüche, **dadurch gekennzeichnet, dass** eine Thermofühlerleitung zur Temperaturüberwachung des Kleintieres (3) vorgesehen, vorzugsweise fix im Schlitten (1) integriert ist.

11. Vorrichtung nach einem der vorgehenden Ansprüche, **dadurch gekennzeichnet, dass** die Vorrichtung eine, vorzugsweise integrierte, Temperiervorrichtung für das Kleintier (3) aufweist.

12. Vorrichtung nach einem der vorgehenden Ansprüche, **dadurch gekennzeichnet, dass** die HF-Antenne (6) in Form, Größe und Position auf dem Schlitten (1) an die Geometrie eines zu untersuchenden Organs des Kleintieres (3) angepasst ist.

13. Verfahren zum Betrieb einer Vorrichtung nach einem der Ansprüche 1 bis 16,
**dadurch gekennzeichnet, dass** die Positionierung der Liege (5) zusammen mit dem Kleintier (3) gegenüber dem Schlitten (1) manuell erfolgt.

14. Verfahren zum Betrieb einer Vorrichtung nach einem der Ansprüche 1 bis 16, **dadurch gekennzeichnet, dass** die Positionierung der Liege (5) zusammen mit dem Kleintier (3) gegenüber dem Schlitten (1) automatisch erfolgt.

15. Verfahren nach Anspruch 17 oder 18, **dadurch gekennzeichnet, dass** zur Bestimmung der Position der ROI (9) des Kleintieres (3) relativ zur HF-Antenne (6) eine MRI-Messung durchgeführt wird.
